# EUROPÄISCHE PATENTSCHRIFT

(11) **EP 2 762 901 B1**
(45) Veröffentlichungstag und Bekanntmachung des Hinweises auf die Patenterteilung: **01.07.2020**
(21) Anmeldenummer: 14153838.9
(22) Anmeldetag: 04.02.2014
(51) Int. Cl.: G01R 11/04, H05K 5/02

(54) **Elektrizitätszähler mit einem Fach zur Aufnahme eines Schilds**
Electricity meter with a compartment for housing a sign
Compteur d'électricité doté d'un compartiment pour le logement d'un panneau

(30) Priorität: 04.02.2013 DE 102013001830
(43) Veröffentlichungstag der Anmeldung: 06.08.2014
(73) Patentinhaber: EMH metering GmbH & Co. KG, 19258 Gallin (DE)
(72) Erfinder: Glomski, Marek, 21035 Hamburg (DE)
(74) Vertreter: Hauck Patentanwaltspartnerschaft mbB

(56) Entgegenhaltungen:
- EP-A1- 0 649 024
- EP-A1- 1 919 269
- WO-A1-00/45184
- DE-U1-202007 011 523
- US-A- 1 940 512
- US-A- 4 977 698

## Beschreibung

Die Erfindung betrifft einen Elektrizitätszähler mit einem Fach zur Aufnahme eines Schilds. Das Schild ist zum Wiedergeben von den Zähler betreffenden Informationen bestimmt und durch ein Sichtfenster in einem Gehäuseteil des Zählers lesbar. Außerdem ist das Fach vor unbefugtem Zugriff geschützt.

Beim Betrieb von Elektrizitätszählern besteht eine Anforderung darin, den Zähler betreffende Informationen dauerhaft und manipulationssicher verfügbar zu halten. Zu diesen Informationen zählen beispielsweise Angaben zu den in Verbindung mit dem Elektrizitätszähler installierten Messwandlern, die unter Umständen zu Abrechnungszwecken benötigt werden. Die Informationen werden beispielsweise bei der Installation des Elektrizitätszählers von einem Servicetechniker auf einem Schild vermerkt. In diesem Fall wird das Schild auch als Messwandlerschild bezeichnet. Anschließend wird das Schild in einem hierfür vorgesehenen Fach des Elektrizitätszählers aufbewahrt. Um eine einfache Manipulation der Informationen auszuschliessen, wird das Fach vor unbefugtem Zugriff geschützt, beispielsweise mit Hilfe einer Plombe.

Bei bekannten Elektrizitätszählern wird das Fach in der Regel mit einer Klappe verschlossen. Die Klappe kann ausschließlich zum Verschließen des Fachs für das Schild vorgesehen sein und mit einer gesonderten Plombe gesichert werden. Ebenfalls bekannt sind Elektrizitätszähler, bei denen eine plombierbare Klappe, mit der das Fach für das Schild abgedeckt wird, zugleich weitere Komponenten des Elektrizitätszählers vor unbefugtem Zugriff schützt.

Aus der Druckschrift EP 0 649 024 A1 ist ein Elektrizitätszähler mit den Merkmalen des Oberbegriffs des Anspruchs 1 bekannt geworden.

Die Druckschrift EP 1 919 269 A1 zeigt ein Gehäuse für einen Elektrizitätszähler mit einem hinter einem Fenster angeordneten Fach, in das ein Schild durch eine seitlich an dem Zähler angeordnete Öffnung eingeschoben wird. Die Öffnung ist relativ zu einer Ebene, in der das Fach angeordnet ist, versetzt angeordnet.

Davon ausgehend ist es die Aufgabe der Erfindung, einen Elektrizitätszähler mit einem Fach zur Aufnahme eines Schilds zur Verfügung zu stellen, der besonders einfach aufgebaut ist und dessen Handhabung hinsichtlich des Schutzes des Fachs vor unbefugtem Zugriff besonders anwenderfreundlich ist.

Diese Aufgabe wird gelöst durch den Elektrizitätszähler mit den Merkmalen des Anspruchs 1. Vorteilhafte Ausgestaltungen sind in den sich anschließenden Unteransprüchen angegeben.

Der Elektrizitätszähler hat ein Gehäuse, das ein erstes Gehäuseteil mit einem Sichtfenster, ein zweites Gehäuseteil, eine plombierbare Abdeckung und ein hinter dem Sichtfenster zwischen dem ersten Gehäuseteil und dem zweiten Gehäuseteil angeordnetes Fach zur Aufnahme eines Schilds aufweist, wobei das Schild zum Wiedergeben von den Zähler betreffenden Informationen bestimmt und durch das Sichtfenster lesbar ist und das Fach vor unbefugtem Zugriff geschützt ist, wobei das Gehäuse eine Öffnung aufweist, die von der plombierbaren Abdeckung abdeckbar ist und durch die das Schild in das Fach eingeschoben werden kann, ohne das erste Gehäuseteil von dem zweiten Gehäuseteil zu entfernen.

Das erste Gehäuseteil und/oder das zweite Gehäuseteil können einteilig gefertigt sein, insbesondere aus einem Kunststoffmaterial und in einem Spritzgießverfahren. Gegebenenfalls kann das Sichtfenster ein gesondertes Bauteil sein, das mit dem ersten Gehäuseteil verbunden ist.

Die Erfindung beruht auf der Erkenntnis, dass die bekannten Elektrizitätszähler mit dem eingangs geschilderten Aufbau in der Regel ein bewegliches Gehäuseteil und eine gesonderte Plombe benötigen, um das Fach zur Aufnahme des Schilds zu verschließen. Die Erfinder haben erkannt, dass auf diese den Aufbau verkomplizierenden Elemente verzichtet werden kann, wenn eine in der Regel ohnehin vorhandene, plombierbare Abdeckung des Elektrizitätszählers gleichsam zum Schutz des Faches vor unbefugtem Zugriff verwendet wird. Hierzu schlägt die Erfindung vor, das Gehäuse des Elektrizitätszählers mit einer Öffnung zu versehen, durch die das Schild in das Fach eingeschoben werden kann. Das Fach ist zwischen zwei Gehäuseteilen des Elektrizitätszählers angeordnet, von denen ein erstes Gehäuseteil ein Sichtfenster aufweist. Die Öffnung erlaubt ein Einschieben des Schildes in das Fach, ohne die beiden Gehäuseteile voneinander zu entfernen. Es ist daher kein zusätzliches bewegliches Gehäuseteil erforderlich, um das Schild in das Fach einzuschieben. Ein wirksamer Schutz des Fachs vor unbefugtem Zugriff ist dennoch gegeben, weil die Öffnung bei der Erfindung von der plombierbaren Abdeckung abgedeckt wird und somit nur dann zugänglich ist, wenn die plombierbare Abdeckung noch nicht montiert ist bzw. wenn sie zuvor wieder entfernt wurde.

Dabei ist es von Vorteil, eine ohnehin vorhandene plombierbare Abdeckung auch zum Schutz des Faches zu verwenden, weil ein Servicetechniker, der beispielsweise mit Wartungsarbeiten an dem Elektrizitätszähler betraut ist, hierzu in der Regel die plombierbare Abdeckung entfernen muss. Er hat dann, ohne zusätzliche Schritte ausführen zu müssen, zugleich Zugang zu dem Fach, falls er Veränderungen an dem Schild vornehmen möchte. Auch bei der Erstinstallation des Elektrizitätszählers ist die erfindungsgemäße Lösung von Vorteil, weil die plombierbare Abdeckung erst nach Abschluss der Installation geschlossen und plombiert wird. Daher kann der die Installation ausführende Techniker das Schild ohne weitere Arbeitsschritte vor Abschluss der Installation, d.h. vor dem Montieren oder Schließen und vor dem Plombieren der Abdeckung, in das Fach einschieben, nachdem er die relevanten Informationen auf dem Schild vermerkt hat. Dadurch ist die Handhabung des Elektrizitätszählers besonders einfach.

Das Schild kann insbesondere eine Karte aus Papier, Pappe, Kunststoff oder einem kunststoffbeschichteten Papiermaterial sein, beispielsweise mit einer rechteckigen Grundform. Das Schild kann ein Feld oder mehrere Felder aufweisen, in die die benötigten Informationen eingetragen werden.

Das erste Gehäuseteil hat ein Sichtfenster, durch das ein in dem Fach angeordnetes Schild lesbar ist. Das Sichtfenster kann insbesondere aus einem transparenten Kunststoffmaterial bestehen. Hinter dem Sichtfenster ist das Fach angeordnet. Auf der Rückseite des Fachs befindet sich das zweite Gehäuseteil, das beispielsweise ein oberes Gehäuseteil, eine Zählerabdeckung oder ein Zwischenboden sein kann. Die Abmessungen des Schildes und des Fachs sind aufeinander abgestimmt. Beispielsweise kann das Fach etwa scheckkartengroß sein und eine Höhe im Bereich von 0,2 mm bis 2 mm aufweisen, sodass das Schild in Form einer Karte mit entsprechender Größe einfach eingeschoben werden kann.

In einer Ausgestaltung können das erste Gehäuseteil und das zweite Gehäuseteil nicht zerstörungsfrei voneinander getrennt werden. In diesem Fall wird das Fach beim Zusammensetzen der beiden Gehäuseteile gebildet und kann nicht geöffnet werden, ohne mindestens eines der Gehäuseteile zu beschädigen. Solange die Öffnung im Gehäuse durch die plombierbare Abdeckung abgedeckt ist, gibt es daher keine Möglichkeit, auf das Fach zuzugreifen, ohne Spuren zu hinterlassen. Insbesondere können das erste Gehäuseteil und das zweite Gehäuseteil miteinander verrastet werden, wobei ein "Ausrasten" der hierfür verwendeten Verrastungselemente zum Beispiel dadurch ausgeschlossen ist, dass diese nicht zugänglich sind. Bei der Erfindung ist ein Trennen der beiden Gehäuseteile voneinander auch nicht erforderlich, um an das Fach zu gelangen, weil hierfür die Öffnung im Gehäuse vorgesehen ist.

In einer Ausgestaltung ist die Öffnung ein Schlitz, der im ersten Gehäuseteil, im zweiten Gehäuseteil oder zwischen dem ersten Gehäuseteil und dem zweiten Gehäuseteil angeordnet ist. Durch den Schlitz kann das Schild in das Fach eingeschoben werden. Je nach Ausformung der Gehäuseteile kann der Schlitz in einem der beiden Gehäuseteile oder zwischen den beiden Gehäuseteilen ausgebildet sein. In jedem Fall kann die Anordnung der Öffnung relativ zu dem Fach allein durch die Gestalt der beiden Gehäuseteile vorgegeben werden, sodass die korrekte Anordnung der Öffnung relativ zu dem Fach sichergestellt ist.

In einer Ausgestaltung ist die Öffnung in einer senkrecht zu einer Frontseite des Zählers angeordneten Gehäusewandung angeordnet. Die Gehäusewandung kann zum Beispiel eine Wandung des ersten und/oder zweiten Gehäuseteils sein. Bei der genannten Anordnung der Öffnung kann das Schild besonders einfach von der Seite in das Fach eingeschoben werden.

Bei der Erfindung ist die Öffnung relativ zu einer Ebene, in der das Fach angeordnet ist, versetzt angeordnet. Beim Einschieben des Schilds durch die Öffnung hindurch in das Fach muss das Schild daher gebogen werden. Hierdurch kann das Schild, wenn es in dem Fach angeordnet ist, unter einer gewissen Spannung stehen, was dazu beitragen kann, dass das Schild an der Innenseite des Sichtfensters anliegt und dadurch besonders gut abgelesen werden kann. Außerdem kann die gebogene Anordnung des Schilds dazu beitragen, dass dieses nicht ohne Überwindung eines gewissen Widerstands verrutschen kann, insbesondere nicht in Richtung wieder aus der Öffnung heraus. Damit das Schild trotz des Versatzes der Öffnung relativ zur Ebene des Fachs einfach eingeschoben werden kann, kann zwischen der Öffnung und dem Fach ein Kanal und/oder eine oder mehrere Führungsflächen ausgebildet sein, sodass die Vorderkante des Schilds beim Einschieben durch die Öffnung in das Fach hineingeführt wird.

In einer Ausgestaltung ist die Ebene parallel zu einer Frontseite des Gehäuses angeordnet und die Öffnung weist einen größeren Abstand von der Frontseite auf als die Ebene. Mit anderen Worten ist die Öffnung relativ zu dem Fach nach hinten bzw. nach innen versetzt angeordnet. Sie ist daher besonders einfach von der plombierbaren Abdeckung abdeckbar, ohne dass die plombierbare Abdeckung hierfür nach vorn über die Frontseite des Gehäuses überstehen muss.

In einer Ausgestaltung weist das Gehäuse im Bereich der Öffnung einen Anschlag auf, der dazu bestimmt ist, ein in das Fach eingeschobenes Schild in dem Fach zu halten. Nach dem Einschieben des Schilds wirkt eine Kante des Schilds mit dem Anschlag zusammen, sodass der Anschlag eine Bewegung des Schilds in der der Richtung des Einschiebens entgegengesetzten Richtung verhindert. Dadurch wird sichergestellt, dass das Schild in der vorgesehenen Anordnung in dem Fach verbleibt.

In einer Ausgestaltung ist der Anschlag an einem rippen-, zapfen- oder pilzkopfförmigen Vorsprung ausgebildet. In der genannten Weise geformte Vorsprünge tragen dazu bei, dass die mit dem Anschlag zusammenwirkende Kante des Schilds nicht ohne Weiteres von dem Anschlag abrutschen kann.

In einer Ausgestaltung ist der Vorsprung an dem ersten Gehäuseteil ausgebildet und weist von einer Frontseite des Elektrizitätszählers weg. Insbesondere weist der Vorsprung von der Frontseite des Zählers nach innen. Insbesondere in Verbindung mit einer nach innen versetzten Öffnung führt diese Maßnahme dazu, dass ein in das Fach eingeschobenes Schild gegen den Anschlag vorgespannt ist und daher nicht ohne Weiteres von dem Anschlag abrutschen kann.

In einer Ausgestaltung ist hinter dem ersten Gehäuseteil eine von außen ablesbare, elektronische Anzeige und/oder eine optische Schnittstelle angeordnet. Dann dient das erste Gehäuseteil nicht nur zur Abdeckung des Fachs für das Schild, sondern zugleich zur Abdeckung der elektronischen Anzeige bzw. der optischen Schnittstelle. Hierzu kann das erste Gehäuseteil ein einziges, entsprechend größer ausgeführtes Sichtfenster oder mehrere Sichtfenster aufweisen.

In einer Ausgestaltung ist das erste Gehäuseteil aus einem transparenten Kunststoffmaterial gefertigt. Dadurch kann das erste Gehäuseteil einschließlich des Sichtfensters besonders einfach gefertigt werden. Hierzu kann das gesamte erste Gehäuseteil mit einer glatten Oberfläche versehen und daher insgesamt durchsichtig sein. Alternativ kann das erste Gehäuseteil nur im Bereich eines oder mehrerer Sichtfenster mit glatten Oberflächen ausgeführt sein, in den benachbarten Bereichen jedoch mit einer rauen oder geriffelten Oberfläche, sodass es dort matt ist.

In einer Ausgestaltung ist die Abdeckung ein Klemmendeckel. Mit dem Klemmendeckel werden die Anschlussklemmen des Elektrizitätszählers für die Verbindung mit einem Versorgungsnetz und/oder mit einem elektrischen Verbraucher abgedeckt. Diese Anschlussklemmen sind in jedem Fall vor unbefugtem Zugriff zu schützen, sodass in der Regel eine plombierbare Abdeckung benötigt wird. Bei der Erfindung wird diese zugleich zum Abdecken der Öffnung für das Fach verwendet.

In einer Ausgestaltung ist der Elektrizitätszähler mit einem Schild kombiniert, wobei das Schild vollständig in das Fach eingeschoben ist und einen zur Beschriftung vorgesehenen Abschnitt aufweist, der hinter dem Sichtfenster angeordnet ist, und einen Handhabungsabschnitt, der aus der Öffnung hervorsteht. Dadurch kann das Schild jederzeit an dem Handhabungsabschnitt aus der Öffnung und dem Fach herausgezogen werden.

In einer Ausgestaltung weist der Handhabungsschnitt eine Öffnung auf, in die ein Vorsprung des Gehäuses eingreift. Durch dieses Eingreifen wird ein unbeabsichtigtes Herausrutschen des Schilds zuverlässig verhindert. Gleichzeitig kann das Schild einfach am Handhabungsabschnitt ergriffen und aus dem Fach entnommen werden, indem die Öffnung entsprechend von dem Vorsprung entfernt wird.

Die Erfindung wird nachfolgend anhand eines in fünf Figuren dargestellten Ausführungsbeispiels näher erläutert. Es zeigen:
- Fig. 1: einen erfindungsgemäßen Elektrizitätszähler in einer perspektivischen Ansicht;
- Fig. 2: das erste Gehäuseteil und das zweite Gehäuseteil des Elektrizitätszähler aus Fig. 1 in einer perspektivischen Ansicht;
- Fig. 3: das erste Gehäuseteil des Elektrizitätszählers aus Fig. 1 in einer perspektivischen Darstellung;
- Fig. 4: einen Ausschnitt der Anordnung aus Fig. 2 in einer Schnittdarstellung;
- Fig. 5: einen weiteren Ausschnitt der Anordnung aus Fig. 2 in einer Schnittdarstellung;

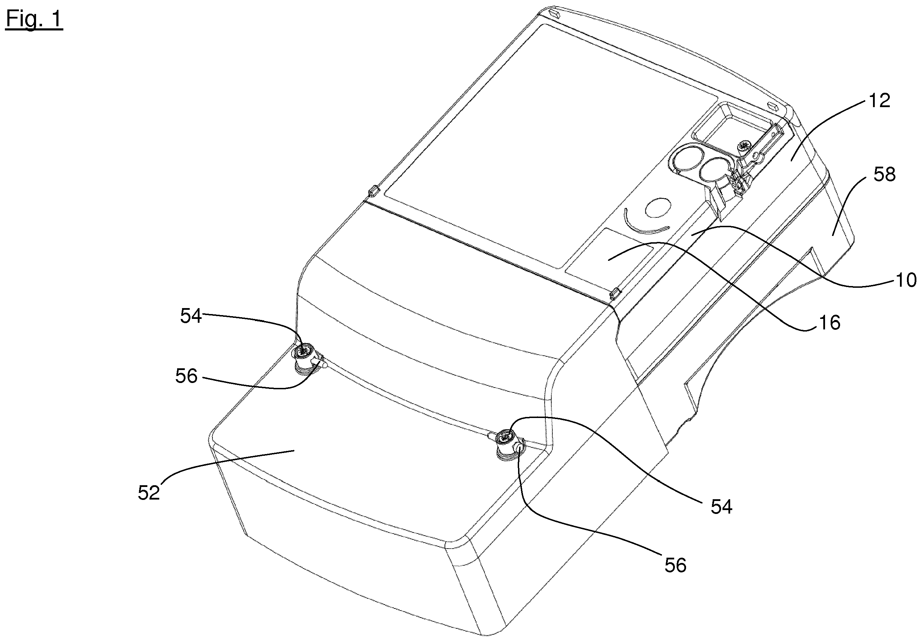

Figur 1 zeigt einen Elektrizitätszähler mit einem ersten Gehäuseteil 10, einem zweiten Gehäuseteil 12 und einem Klemmendeckel 52. Im ersten Gehäuseteil ist ein Sichtfenster 16 erkennbar, hinter dem ein Schild angeordnet werden kann. Der Klemmendeckel 52 ist plombiert. Hierzu ist er mit zwei Plombierschrauben 54 befestigt, die jeweils mit einer Stiftplombe 56 gesichert sind. Ein Entfernen des Klemmendeckels ist nur unter Beschädigung der Stiftplomben 56 möglich. Das erste Gehäuseteil 10 ist mit dem zweiten Gehäuseteil 12 verbunden. Unterhalb des zweiten Gehäuseteils 12 befindet sich noch ein weiteres Gehäuseteil 58, das eine Grundplatte des Zählers aufweist.

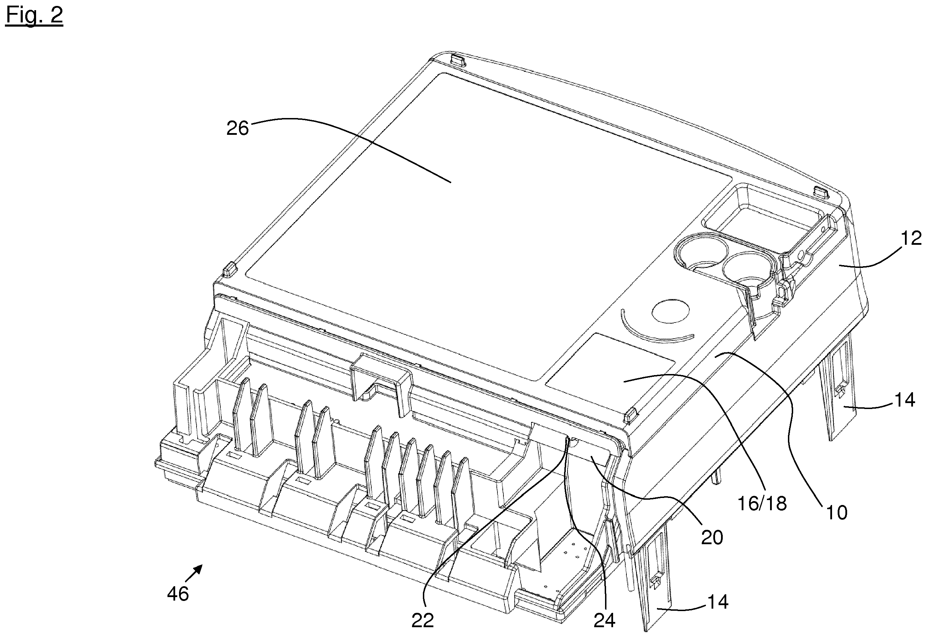

In der Fig. 2 sind nur das erste Gehäuseteil 10 und das zweite Gehäuseteil 12 des Elektrizitätszählers dargestellt. Das zweite Gehäuseteil 12 weist zur Verbindung mit dem weiteren Gehäuseteil 58 des Elektrizitätszählers mehrere Verriegelungselemente 14 auf. Das erste Gehäuseteil 10 ist mit dem zweiten Gehäuseteil 12 derart verbunden, dass die beiden Gehäuseteile 10, 12 nicht zerstörungsfrei voneinander getrennt werden können. Hierzu sind die beiden Gehäuseteile 10, 12 miteinander verrastet. Das erste Gehäuseteil 10 weist ein Sichtfenster 16 auf, hinter dem ein zur Beschriftung vorgesehener Abschnitt eines Schilds 18 angeordnet ist. Das Schild 18 ist in einem Fach angeordnet, das zwischen dem Sichtfenster 16 des ersten Gehäuseteils und dem zweiten Gehäuseteil 12 ausgebildet ist.

In der Fig. 2 vorn erkennt man einen Bereich 46 des Elektrizitätszählerbereich, der nahe der Anschlussklemmen des Elektrizitätszählers angeordnet ist und von dem Klemmendeckel 52 (siehe Fig. 1) abgedeckt wird.

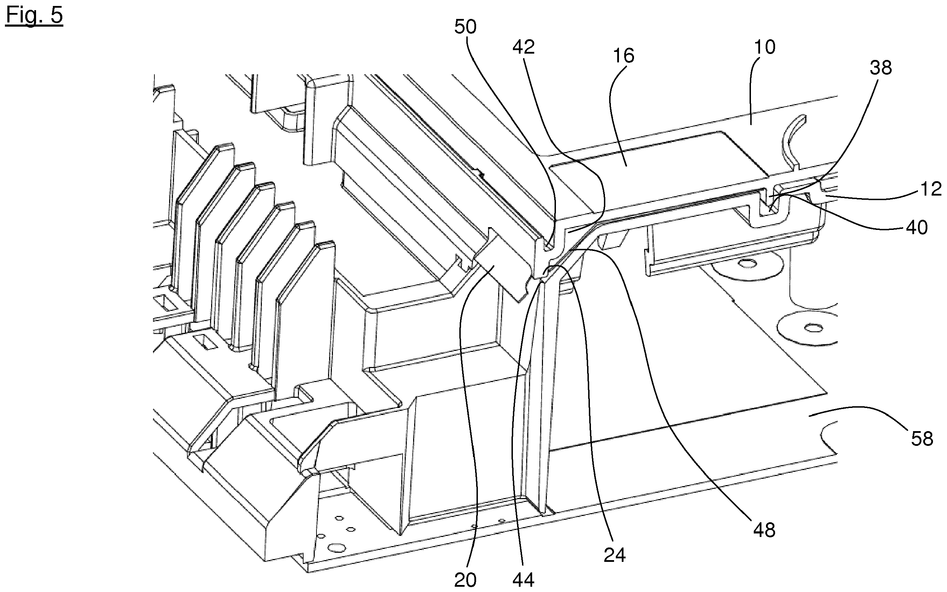

Das Fach ist bei entferntem Klemmendeckel 52 durch eine in der Fig. 2 nicht im Einzelnen erkennbare Öffnung 44 (siehe Fig. 5) zugänglich, die in Form eines zwischen dem ersten Gehäuseteil 10 und dem zweiten Gehäuseteil 12 ausgebildeten Schlitzes vorhanden ist und aus der ein Handhabungsabschnitt 20 des Schilds 18 hervorsteht. Der Handhabungsabschnitt 20 weist eine Öffnung 22 in Form eines Lochs auf, in die ein Vorsprung 24 eingreift, um ein Herausrutschen des Schilds 18 aus dem Fach zu verhindern. Der Vorsprung 24 ist am ersten Gehäuseteil 10 ausgebildet und weist von einer Frontseite 26, die ebenfalls von dem ersten Gehäuseteil 10 gebildet wird, weg.

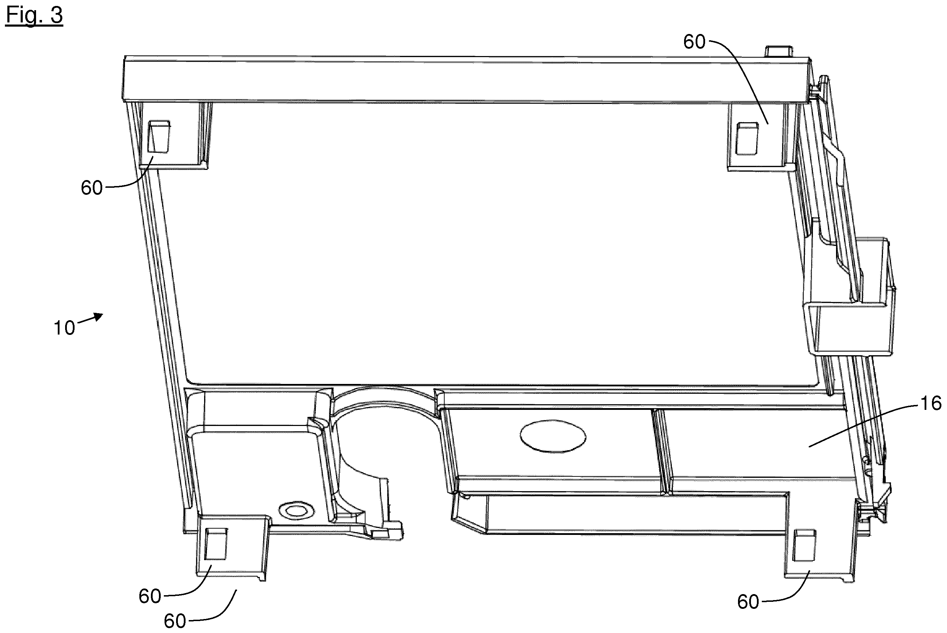

Die Form des ersten Gehäuseteils 10 ist besser in der Fig. 3 erkennbar, in der das erste Gehäuseteil 10 allein dargestellt ist. Es besteht vollständig aus einem transparenten Kunststoffmaterial. In der Fig. 3 ist der Blick auf die Innenseite des ersten Gehäuseteils 10 gerichtet. Man erkennt das Sichtfenster 16, hinter dem das Schild angeordnet wird und welches das Fach zur Frontseite 26 des Elektrizitätszählers hin begrenzt. Außerdem erkennt man in der Fig. 3 vier Verriegelungsabschnitte 60, die bei Verbindung des ersten Gehäuseteils 10 mit dem zweiten Gehäuseteil 12 im zweiten Gehäuseteil 12 einrasten, sodass die beiden Gehäuseteile 10, 12 nicht mehr zerstörungsfrei voneinander getrennt werden können. Ein (unbemerkt bleibender) Zugang zu dem Fach durch Entfernen des ersten Gehäuseteils 10 ist daher ausgeschlossen.

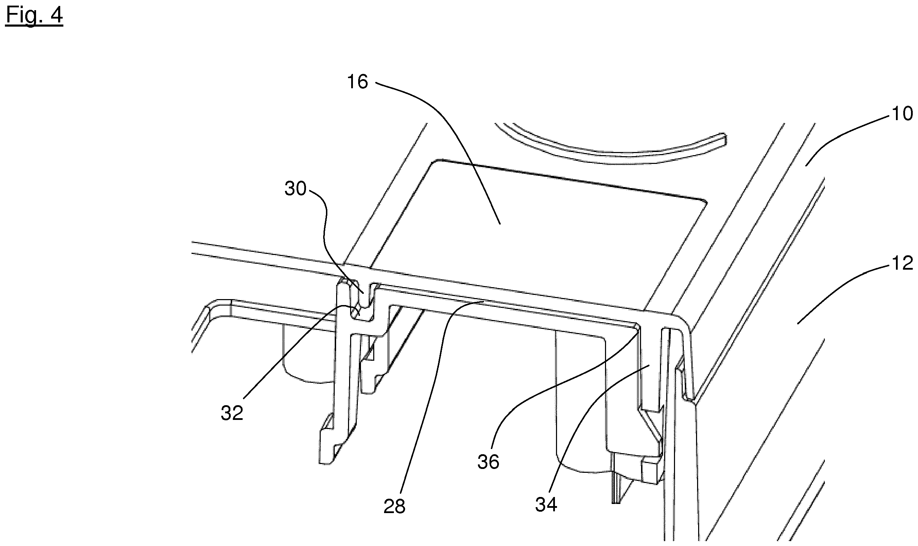

Einzelheiten des Fachs und der Öffnung 44 sind besser in den Fign. 4 und 5 erkennbar. In der Fig. 4 verläuft die Schnittebene senkrecht zur Frontseite 26 des Elektrizitätszählers und in dessen Querrichtung. Man erkennt das erste Gehäuseteil 10 mit dem Sichtfenster 16 sowie das hinter dem Sichtfenster 16 ausgebildete Fach, das nach unten von einer ebenen Fläche 28 des zweiten Gehäuseteils 12 abgeschlossen wird.

Seitlich wird das Fach nach links von einem am ersten Gehäuseteil 10 ausgebildeten Steg 30 begrenzt, der in eine Nut 32 im zweiten Gehäuseteil 12 eingreift. Nach rechts wird das Fach begrenzt von einem weiteren Steg 34 des ersten Gehäuseteils 10, der einen Rand 36 der ebenen Fläche 28 des zweiten Gehäuseteils 12 umschließt.

In der Fig. 5 verläuft die Schnittebene ebenfalls senkrecht zur Frontseite 26 des Elektrizitätszählers, jedoch im rechten Winkel zur Schnittebene der Fig. 4, also in Längsrichtung des Elektrizitätszählers. Man erkennt in dieser Darstellung, dass das unterhalb des Sichtfensters 16 ausgebildete Fach nach hinten von einem weiteren Steg 38 begrenzt wird, der am ersten Gehäuseteil 10 ausgebildet ist und in eine gegenüberliegende Nut 40 im zweiten Gehäuseteil 12 eingreift. Nach vorn ist das Fach offen und über einen Freiraum 42 zwischen dem ersten Gehäuseteil 10 und dem zweiten Gehäuseteil 12 mit einer schlitzförmigen Öffnung 44 verbunden, aus der der Handhabungsabschnitt 20 des Schilds heraussteht. Man erkennt außerdem den Vorsprung 24, dessen Mitte in der Schnittebene angeordnet ist.

Die Fig. 5 zeigt, dass die Öffnung 44 gegenüber der Ebene des Fachs nach unten versetzt angeordnet ist. Man erkennt weiter, dass das zweite Gehäuseteil 12 eine schräg angeordnete Führungsfläche 48 aufweist, die die Vorderkante eines durch die Öffnung 44 eingeschobenen Schilds 18 in das Fach hinein führt. Oberhalb der Öffnung 44 weist das erste Gehäuseteil 10 eine in Querrichtung des Zählers verlaufende Nut 50 auf, in die der in der Fig. 5 nicht dargestellte Klemmendeckel 52 eingreift. Dadurch wird die Öffnung 44 von dem Klemmendeckel 52 gemeinsam mit den Anschlussklemmen abgedeckt, sodass ein unbefugter Zugriff zu dem Fach durch die Öffnung 44 nicht möglich ist.

### Liste der verwendeten Bezugszeichen:

- 10: erstes Gehäuseteil
- 12: zweites Gehäuseteil
- 14: Verriegelungselemente
- 16: Sichtfenster
- 18: Schild
- 20: Handhabungsabschnitt
- 22: Öffnung
- 24: Vorsprung
- 26: Frontseite
- 28: ebene Fläche
- 30: Steg
- 32: Nut
- 34: Steg
- 36: Rand
- 38: Steg
- 40: Nut
- 42: Freiraum
- 44: Öffnung
- 46: Bereich
- 48: Führungsfläche
- 50: Nut für Klemmendeckel
- 52: Klemmendeckel
- 54: Plombierschraube
- 56: Stiftplombe
- 58: weiteres Gehäuseteil
- 60: Verriegelungsabschnitt

## Patentansprüche

1. Elektrizitätszähler mit einem Gehäuse, das ein erstes Gehäuseteil (10) mit einem Sichtfenster (16), ein zweites Gehäuseteil (12), eine plombierbare Abdeckung und ein hinter dem Sichtfenster (16) zwischen dem ersten Gehäuseteil (10) und dem zweiten Gehäuseteil (12) angeordnetes Fach zur Aufnahme eines Schilds (18) aufweist, wobei das Schild (18) zum Wiedergeben von den Zähler betreffenden Informationen bestimmt und durch das Sichtfenster (16) lesbar ist und das Fach vor unbefugtem Zugriff geschützt ist, wobei das Gehäuse eine Öffnung (44) aufweist, die von der plombierbaren Abdeckung abdeckbar ist und durch die das Schild (18) in das Fach eingeschoben werden kann, ohne das erste Gehäuseteil (10) von dem zweiten Gehäuseteil (12) zu entfernen, **dadurch gekennzeichnet, dass** die Öffnung (44) relativ zu einer Ebene, in der das Fach angeordnet ist, versetzt angeordnet ist.

2. Elektrizitätszähler nach Anspruch 1, **dadurch gekennzeichnet, dass** das erste Gehäuseteil (10) und das zweite Gehäuseteil (12) nicht zerstörungsfrei voneinander getrennt werden können.

3. Elektrizitätszähler nach Anspruch 1 oder 2, **dadurch gekennzeichnet, dass** die Öffnung (44) ein Schlitz ist, der im ersten Gehäuseteil (10), im zweiten Gehäuseteil (12) oder zwischen dem ersten Gehäuseteil (10) und dem zweiten Gehäuseteil (12) angeordnet ist.

4. Elektrizitätszähler nach einem der Ansprüche 1 bis 3, **dadurch gekennzeichnet, dass** die Öffnung (44) in einer senkrecht zur einer Frontseite (26) des Elektrizitätszählers angeordneten Gehäusewandung angeordnet ist.

5. Elektrizitätszähler nach einem der Ansprüche 1 bis 4, **dadurch gekennzeichnet, dass** die Ebene parallel zur einer Frontseite (26) des Gehäuses angeordnet ist und die Öffnung (44) einen größeren Abstand von der Frontseite (26) aufweist als die Ebene.

6. Elektrizitätszähler nach einem der Ansprüche 1 bis 5, **dadurch gekennzeichnet, dass** das Gehäuse im Bereich der Öffnung (44) einen Anschlag aufweist, der dazu bestimmt ist, ein in das Fach eingeschobenes Schild (18) in dem Fach zu halten.

7. Elektrizitätszähler nach Anspruch 6, **dadurch gekennzeichnet dass** der Anschlag an einem rippen-, zapfen- oder pilzkopfförmigen Vorsprung (24) ausgebildet ist.

8. Elektrizitätszähler nach Anspruch 7, **dadurch gekennzeichnet dass** der Vorsprung (24) an dem ersten Gehäuseteil (10) ausgebildet ist und von einer Frontseite (26) des Elektrizitätszählers weg weist.

9. Elektrizitätszähler nach einem der Ansprüche 1 bis 8, **dadurch gekennzeichnet dass** hinter dem ersten Gehäuseteil (10) eine von außen ablesbare, elektronische Anzeige und/oder eine optische Schnittstelle angeordnet ist.

10. Elektrizitätszähler nach einem der Ansprüche 1 bis 9, **dadurch gekennzeichnet dass** das erste Gehäuseteil (10) aus einem transparenten Kunststoffmaterial gefertigt ist.

11. Elektrizitätszähler nach einem der Ansprüche 1 bis 10, **dadurch gekennzeichnet dass** die plombierbare Abdeckung ein Klemmendeckel (52) ist.

12. Elektrizitätszähler nach einem der Ansprüche 1 bis 11 mit einem Schild (18), **dadurch gekennzeichnet, dass** das Schild (18) vollständig in das Fach eingeschoben ist und einen zur Beschriftung vorgesehenen Abschnitt aufweist, der hinter dem Sichtfenster (16) angeordnet ist, und einen Handhabungsabschnitt (20), der aus der Öffnung (44) hervorsteht.

13. Elektrizitätszähler nach Anspruch 12, **dadurch gekennzeichnet, dass** der Handhabungsabschnitt (20) eine Öffnung (22) aufweist, in die ein Vorsprung (24) des Gehäuses eingreift.

## Claims

1. Electricity meter comprising a housing having a first housing part (10) with a viewing window (16), a second housing part (12), a sealable cover, and a compartment for receiving a label (18) arranged behind the viewing window (16) between the first housing part (10) and the second housing part (12), the label (18) being intended for displaying information relating to the meter and being readable through the viewing window (16), and the compartment being protected against unauthorized access, the housing having an opening (44) which can be covered by the sealable cover and through which the label (18) can be inserted into the compartment without removing the first housing part (10) from the second housing part (12), **characterized in that** the opening (44) is offset relative to a plane in which the compartment is located.

2. Electricity meter according to claim 1, **characterized in that** the first housing part (10) and the second housing part (12) cannot be separated from one another in a non-destructive manner.

3. Electricity meter according to claim 1 or 2, **characterized in that** the opening (44) is a slot which is arranged in the first housing part (10), in the second housing part (12) or between the first housing part (10) and the second housing part (12).

4. Electricity meter according to one of claims 1 to 3, **characterized in that** the opening (44) is arranged in a housing partition arranged perpendicular to a front side (26) of the electricity meter.

5. Electricity meter according to one of claims 1 to 4, **characterized in that** the plane is arranged parallel to a front side (26) of the housing and the opening (44) has a greater distance from the front side (26) than the plane.

6. Electricity meter according to one of claims 1 to 5, **characterized in that** the housing has a stop in the area of the opening (44), which is intended to hold a label (18) which is inserted into the compartment in the compartment.

7. Electricity meter according to claim 6, **characterized in that** the stop is formed on a ribbed, spigot or mushroom-shaped projection (24).

8. Electricity meter according to claim 7, **characterized in that** the projection (24) is formed on the first housing part (10) and faces away from a front side (26) of the electricity meter.

9. Electricity meter according to one of claims 1 to 8, **characterized in that** an electronic display and/or an optical interface which can be read from the outside is arranged behind the first housing part (10).

10. Electricity meter according to one of claims 1 to 9, **characterized in that** the first housing part (10) is made of a transparent plastic material.

11. Electricity meter according to any of claims 1 to 10, **characterized in that** the sealable cover is a terminal cover (52).

12. Electricity meter according to one of claims 1 to 11 with a label (18), **characterized in that** the label (18) is fully inserted into the compartment and has a portion provided for inscription, which is arranged behind the viewing window (16), and a handling portion (20) which protrudes from the opening (44).

13. Electricity meter according to claim 12, **characterized in that** the handling portion (20) has an opening (22) in which a projection (24) of the housing engages.

## Revendications

1. Compteur d'électricité comprenant un boîtier présentant une première partie de boîtier (10) avec une fenêtre d'observation (16), une deuxième partie de boîtier (12), un capot plombable et un compartiment disposé derrière la fenêtre d'observation (16), entre la première partie de boîtier (10) et la deuxième partie de boîtier (12), pour le logement d'un panneau (18), dans lequel le panneau (18) est conçu pour reproduire des informations concernant le compteur et peut être lu à travers la fenêtre d'observation (16), et le compartiment est protégé contre un accès non autorisé, dans lequel le boîtier présente une ouverture (44) susceptible d'être recouverte par le capot plombable et à travers laquelle le panneau (18) peut être inséré dans le compartiment, sans éloigner la première partie de boîtier (10) de la deuxième partie de boîtier (12), **caractérisé en ce que** l'ouverture (44) est disposée de façon décalée par rapport à un plan dans lequel est disposé le compartiment.

2. Compteur d'électricité selon la revendication 1, **caractérisé en ce que** la première partie de boîtier (10) et la deuxième partie de boîtier (12) ne peuvent pas être séparées l'une de l'autre sans destruction.

3. Compteur d'électricité selon la revendication 1 ou 2, **caractérisé en ce que** l'ouverture (44) est une fente disposée dans la première partie de boîtier (10), dans la deuxième partie de boîtier (12) ou entre la première partie de boîtier (10) et la deuxième partie de boîtier (12).

4. Compteur d'électricité selon l'une des revendications 1 à 3, **caractérisé en ce que** l'ouverture (44) est disposée dans une paroi de boîtier disposée perpendiculairement à un côté frontal (26) du compteur d'électricité.

5. Compteur d'électricité selon l'une des revendications 1 à 4, **caractérisé en ce que** le plan est disposé parallèlement à un côté frontal (26) du boîtier et l'ouverture (44) présente un espacement plus grand par rapport au côté frontal (26) que le plan.

6. Compteur d'électricité selon l'une des revendications 1 à 5, **caractérisé en ce que** le boîtier présente une butée dans la région de l'ouverture (44), laquelle est conçue pour maintenir le panneau (18) inséré dans le compartiment.

7. Compteur d'électricité selon la revendication 6, **caractérisé en ce que** la butée est réalisée sur une saillie (24) en forme de nervure, d'ergot ou de champignon.

8. Compteur d'électricité selon la revendication 7, **caractérisé en ce que** la saillie (24) est réalisée sur la première partie de boîtier (10) et orientée à distance du côté frontal (26) du compteur d'électricité.

9. Compteur d'électricité selon l'une des revendications 1 à 8, **caractérisé en ce qu'**un écran électronique et/ou une interface optique lisible depuis l'extérieur est disposé(e) derrière la première partie de boîtier (10).

10. Compteur d'électricité selon l'une des revendications 1 à 9, **caractérisé en ce que** la première partie de boîtier (10) est constituée d'une matière plastique transparente.

11. Compteur d'électricité selon l'une des revendications 1 à 10, **caractérisé en ce que** le capot plombable est un couvre-bornes (52).

12. Compteur d'électricité selon l'une des revendications 1 à 11, avec un panneau (18), **caractérisé en ce que** le panneau (18) est inséré entièrement dans le compartiment et présente une section destinée à porter des inscriptions, laquelle est disposée derrière la fenêtre d'observation (16), et une section de manipulation (20) faisant saillie hors de l'ouverture (44).

13. Compteur d'électricité selon la revendication 12, **caractérisé en ce que** la section de manipulation (20) présente une ouverture (22) dans laquelle s'engage une saillie (24) du boîtier.
